(19) Europäisches Patentamt / European Patent Office / Office européen des brevets

(11) **EP 2 202 806 A1**

(12) **EUROPEAN PATENT APPLICATION**
published in accordance with Art. 153(4) EPC

(43) Date of publication:
**30.06.2010  Bulletin 2010/26**

(51) Int Cl.:
**H01L 31/052** (2006.01)    **G02F 1/29** (2006.01)

(21) Application number: **08838579.4**

(22) Date of filing: **08.10.2008**

(86) International application number:
**PCT/ES2008/000631**

(87) International publication number:
**WO 2009/050314 (23.04.2009 Gazette 2009/17)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **17.10.2007  ES 200702730**

(71) Applicant: **Universidad Politécnica de Madrid 28040 Madrid (ES)**

(72) Inventors:
- **LUQUE LÓPEZ, Antonio**
  **E-28040 Madrid (ES)**
- **MARTI VEGA, Antonio**
  **E-28040 Madrid (ES)**

(74) Representative: **Carvajal y Urquijo, Isabel et al Clarke, Modet & C.**
**C/ Goya, 11**
**28001 Madrid (ES)**

(54) **QUANTUM DOT INTERMEDIATE BAND SOLAR CELL WITH OPTIMAL CONNECTION OF LIGHT BY DIFFRACTION**

(57)    It consists of a quantum dot intermediate band solar cell with light coupling by diffraction. In the structure of the cell, the rear metalic contact (7) is separated from the semiconductor (1) by a low refraction index layer (8). It also contains a number of grooves (9) on the front face covered by one or more antireflecting layers (10) which are also part of the diffractive structure. The grooves (9) are designed in such a way that they difract on the infrared range the light cone coming from a concentrator, leaning them as much as possible. In this way, the luminous electromagnetic power flux is increased facilitating its absorption by the quantum dot layer (4). Layer (8) produces a total internal reflection of the rays inclined by (9).

FIG. 1

**Description**

**Technical Sector**

Energy technology (photovoltaic converters), optoelectronic technology (LEDs and lasers), laboratory instrumentation (photodetectors).

**State of the Art**

In a conventional solar cell, current and voltage are determined by the value of the bandgap. High values produce low currents (few photons are absorbed) and high voltages, and viceversa. Theoretically, an optimum occurs (for isotropic solar illumination) at aproximately the forbiden bandgap of silicon.

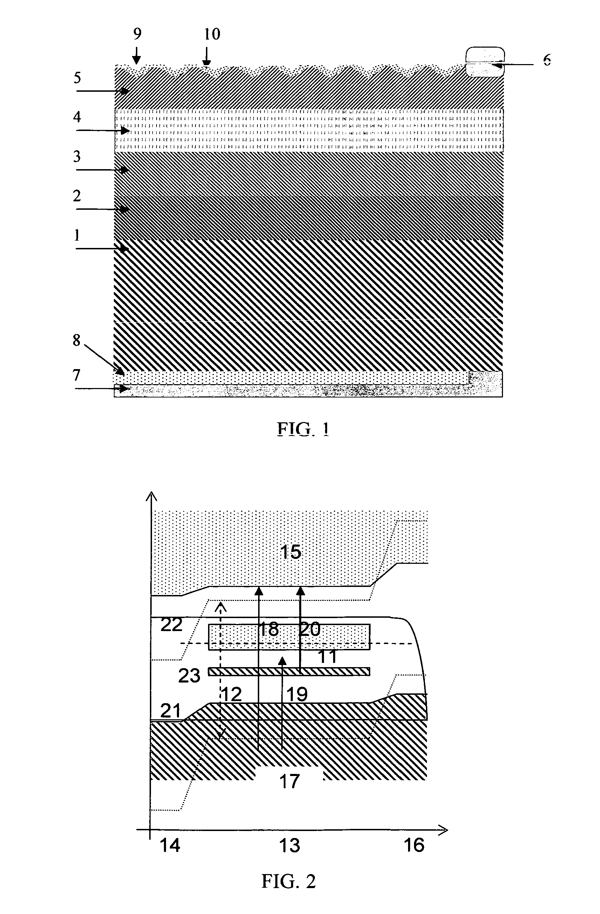

According to a procedure we have patented (EP 1 130 657, A2 P9901278, US 6,444,897) it is possible to simultaneously achieve high current and high voltage with a material with an intermediate band (IB) (11) allowed in the middle of the forbiden band (12) of the semiconductor as shown in Figure 2. The solar cell is completed by placing the intermediate band material (13) in-between two conventional semiconductors, one of them n-type (14) for contacting the conduction band (CB) (15) and the other one of p-type (16) for contacting the valence band (VB) (17). The intermediate band is thus isolated from the metallic contacts, which in a solar cell are typically located on both its front (in the shape of a grid) and rear face.

In this cell, in adittion to the conventional process of electron pumping from the VB to the CB by means of a photon of sufficient energy (18), we must consider a pumping process in two steps. The first step takes place from the VB to the IB and is produced by a photon with lower energy (19) followed by the pumping from the IB to the CB by menas of a second photon also with lower energy than the bandgap (20). The maximum possible photovoltaic conversion efficiency achieved with this structure is on the range of 63.2. % to be compared with the 40.7 % limit shown by cells with a single forbidden band, or the 55.4 % reached through the combination of two cells made of different materials. Indeed, the optimum value of the forbidden band is not now that of silicon (1.1 e.V.) but 1.95 e.V. with the forbidden sub-bands being of 0.74 y 1.21 e.V.

The achievement of high voltages will depend on the existence of three different electrochemical potentials (or quasi-Fermi levels) one for the valence band (21), one for the conduction band (22) and the third one for the intermediate band (23).

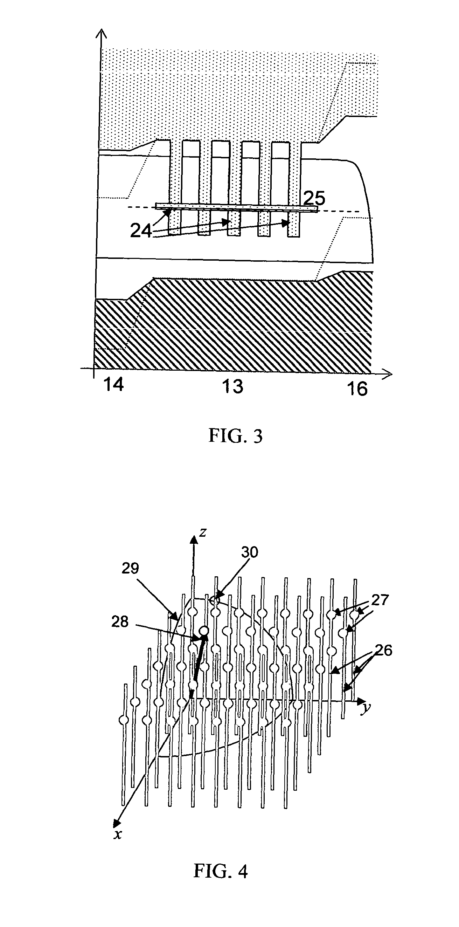

The manufacturing of the intermediate band solar cell using quantum dot technology (24) (see Figure 3) has already been developed, (A. Luque, A. Martí, C. Stanley, N. López, L. Cuadra, D. Zhou y A. Mc- Kee, Journal of Applied Physics, 96, pag. 903, 2004). In this device, the intermediate band rises up from the energy level of the electrons confined in the dots (25) (see Figure 3). Up to now, intermediate band quantum dot solar cells have reached performances of a 9%. However, the potential is, as we said before, rather high and the low performances achieved in practical devices are mainly due to the low photon absorption provided by the intermediate band and is caused by the low density of absorption centres (less than $10^{17}$ cm$^{-3}$) of the quantum dot material. This patent, which includes some modifications related to the manufacturing of the solar cell, leads to solve this problem.

On the other hand, this patent is related to the development of light confinement systems based on light diffraction. Patents US 4398056 and 4536608, already in 1983 describe a diffraction grid of rectangular profile (in the first) or a whole of depressions or protuberances of rectangular profile and hexagonal base (in the second) located on the rear face of the solar cell to bend the luminous rays and achieve a higher optical path into the material constituing the solar cell. In 1989, RH Morf and H Kiess, ("Submicron gratings for light trapping in silicon solar cells: a theoretical study", Proc. 9th Photovoltaic Solar Energy Conf., 313-315, 1989) published an experimental study of a diffraction grid, of the same nature than the one described on the first patent, with positive results. In 1992, Morf describes on his patent WO92/14270 other shapes for the diffraction grid on the rear face, including not only rectangular, but also triangular profiles (by extrapolating sequences of rectangular profiles). In 1996 Takahisa and his collaborators proposed, in the patent JP8046227, a diffractive structure of a special shape located on the cell surface and therefore, working in transmission mode. On the other hand, in 2001 Shinichi locates in his Patent JP2001127313 the diffraction grid inside the solar cell, although such grid still operates by reflection. The general objective of all these patents is to incline the trajectory of the incident rays of light onto, either a thin, or a low photon absorbing layer thus increasing its trajectory and, therefore, its absorption. In this sense, it must be taken into account the study of the electromagnetic energy confining limits developed in 1991 by one of the inventors (A. Luque, "The Confinement of Light in Solar-Cells," Solar Energy Materials, vol. 23, pp. 152-163, Dec 1991) for a variety of compatible structures with solar cells, and particularly, with a diffraction structure of any kind).

Nevertheless, none of the mentioned patents involve an intermediate band solar cell. More specifically, this patent applies the concept of diffractive grids and structures to the intermediate band solar cells in order to increase the absorption provided by the quantum dots that originate the intermediate band or any other element able to produce it.

The above-mentioned study of limits is taken into account in this patent to propose, for the first time, optimized difractive structures.

## Description of the Invention

Our invention consists of an intermediate band solar cell characterized' by the inclusion of a grid of centres or difraction lines either on the front or on the rear face, or even inside the cell in-between two materials of different refraction indexes. This grid deviates the sunlight sideways into the cell and increases the light absorption by increasing the number of transitions between the intermediate band and the valence band (19) of these cells, or between the intermediate band and the conduction band (20) or both simultaneously. Diffractive centres can either be polygonal basis pyramids (triangles, squares, etc.) or planes forming to a diedro. The diffraction grid is formed by repeating these centres following a periodical layout. The centres are separated in such a way that for any of the directions of illumination and for a given light wavelengh in vacuum, the directions of constructive interference are parallel to the surface of the film in which the solar cell is manufactured.

Our description will start with a review of the intermediate band solar cell. It is tipically constituted (see Figure 1) by a monocrystalline semiconductor substrate (1) onto which an epitaxial buffer layer (2) is deposited to separate and couple the substrate of the active part of the cell, a n-type conductivity (or alternatively p-type) base epitaxial layer (3), an intermediate band layer (4), and a p-type (or alternatively n-type) emitter layer (5). It is also provided with a metallic contact grid (6) on the upper face and another contact (7) on the lower face, which is partially separated from the semiconductor through a low refraction index layer (8).

In adition to the mentioned layers, additional layers can exist for different purposes as, for example, avoiding the perforation of the intermediate band caused by tunnel effect (A. Martí, E. Antolin, E. Cánovas, N. López, A. Luque, C. Stanley, C. Farmer, P. Diaz, C. Christofides, and M. Burhan, "Progress in quantum-dot intermediate band solar cell research," in Proc. of the 21st European Photovoltaic Solar Energy Conference, Munich: WIP-Renewable Energies, 2006, pp. 99-102). Also, some of the described layers could be disregarded (e.g. the buffer layer buffer 2).

As far as we know, the only intermediate band material to manufacture solar cells obtained to date is made of quantum dots, and more precisely, of indium arsenide dots in a gallium arsenide matrix. The low density of these quantum dots, lower than $10^{17}$ cm$^{-3}$, is due to the relatively large size of the dots, an inherent fact to quantum dot cells. Consequently, it is convenient to increase the light absorption provided by this quantum dot layer and therefore, increase the luminous power on them. This can be achieved by means of the diffractive structures described in this patent placed on the front face, on the rear face or on an internal layer of the cell between two materials with different refraction index.

The physical model allowing to analyze the light diffraction in these structures and, therefore, optimize them, is based on a hitherto unknown method to treat the diffraction theory developed by the authors, which will be next briefly explained:

Let us suppose a diffraction centre illuminated by an electromagnetic plane wave with a $k_0$ wave vector and polarization according to the *x* axis.

$$E_i = E_0 u_x \exp(ik_0 r - i\omega t) \quad \forall \quad \omega = k_0 c / n = k_0 / \sqrt{\varepsilon\mu} \tag{1}$$

where *c* is the speed of light in the vacuum and *n* is the refraction index of the medium propagating the wave. Vectors will be written in bold and italics and their modules in italics; *x,y,z* will describe the Cartesian coordinates of the ordinary space and *t* the time. Unitary vectors will be called *u.*

Such diffraction centre can be considered the origin of a spherical wave

$$E_d(r) = \frac{E_0 \Lambda(\varphi,\theta)}{r} \exp i(k_0 r - \omega t)$$

$$\forall \quad r = \sqrt{x^2 + y^2 + z^2}, \quad \theta = \arccos(z/r), \quad \varphi = \arccos\left(\frac{x}{r\sin(z)}\right) \tag{2}$$

If the diffraction centre is displaced a vector **d**, small with respect to the position **r** where the diffracted field is to be known, we obtain

$$\mathbf{E}_d(\mathbf{r}) \cong \frac{E_0 \Lambda(\varphi, \theta)}{r} \exp i(k_0 r - \omega t) \exp(-i(k_0 \mathbf{u}_r - \mathbf{k}_0)\mathbf{d}) \tag{3}$$

This formula is valid for **r** values high enough so that the displaced diffraction centre is seen in the same direction than the one not displaced. However, d is not small with respect to the wavelenght $\lambda_0 = 2\pi/k_0$.

If instead of a single diffraction centre we had a tridimensional grid $a = m_1 a_1 + m_2 a_2 + m_3 a_3$ of identical centres (being $m_1$, $m_2$ $m_3$ any integers) the diffracted wave at a sufficient long distance from these centres will be:

$$E_d(r) \cong E_0 \Delta(r) \exp(ik_0 r) \sum_{m1,m2,m3} \exp\left(-i(k_0 u_r - k_0)a_{m1,m2,m3}\right) \tag{4}$$

whose sumatory will, in general, become nule as it refers to complex values characterised by almost aleatory phase. This will not be the case if:

$$k_0 u_r - k_0 = 2\pi B \quad o \quad u_r = B\lambda_0 + k_0/k_0 = B\lambda_0 + u_0 \tag{5}$$

in which case it will become N, that is, the number of diffraction centres. In the previous formulae, $B = p_1 B_1 + p_2 B_2 + p_3 B_3$ where $p_1$, $p_2$, $p_3$ are any integers and $B_1 = (a_2 \times a_3)/a_1(a_2 \times a_3)$ is a base vector of the reciprocal lattice. $B_2$ and $B_3$ are obtained by ciclical permutation of the indexes.

Therefore, $u_r$ directions at which constructive interferences take place are given by the reciprocal lattice vectors, multiplied by the wavelength and displaced by a unitary vector in the illumination direction. However, $u_r$ must also be a unitary vector and therefore, its extreme must be located at the unit radius sphere. It may be difficult to find $u_r$ vectors complying with this condition, which means that it may not be easy to find constructive interference directions.

Spetial cases where the appearence of constructive interference is easier are those of flat grids of diffraction dots and diffractive lines, producing diffracting grids.

In the first case, the bidimensional grid formed by the dots $a = m_1 a_1 + m_2 a_2$, which will be assumed entirely contained in the plane $(x,y)$ can be considered a tridimensional grid $a = m_1 a_1 + m_2 a_2 + m_3 u_z \Omega$ with $\Omega \to \infty$; this is, $a_3 = u_z \Omega$.

The reciprocal lattice base vectors are $B_1 = \dfrac{a_2 \times u_z}{a_1(a_2 \times u_z)}$, $B_2 = \dfrac{u_z \times a_1}{a_2(u_z \times a_1)}$ and

$B_3 = \dfrac{a_1 \times a_2}{\Omega u_z(a_2 \times a_1)} = \varpi u_z$ with $\varpi \to 0$. As it is represented in Figure 4, the reciprocal lattice is now formed by lines (26) coming out from the elements (27) of the bidimensional reciprocal lattice which base is determined by $B_1$ and $B_2$ multiplied by $\lambda_0$ (this is, the base of Figure 4 is $B_1 \lambda_0$ and $B_2 \lambda_0$) displaced by a vector $u_0$ in the illumination direction (28). Some of these lines intersect the unit radius sphere (29), which is the one marked with number (30). Obviously many lines (26) (the most external ones) do not have any intersection and therefore, do not produce any constructive direction for diffraction.

On the other hand, those that intersect have a second one symmetric with respect to the plane $(x,y)$ which means that the constructive directions of the upper hemisphere are related to those of the lower hemisphere. However, given that the surface containing the diffraction centres is usually the frontier between two media of different diffraction indexes, a different value of $k = n\omega/c$ has to be applied in each hemisphere and, therefore, a different value of $\lambda$. Because of this, the symmetry between both hemispheres does not exist anymore.

Given the case in which diffraction centres consists of lines, all of them on the same plane forming diffraction grids, we can consider that the base vectors of the grid of centres is given by the vectors $a_1 = \varepsilon u_1$ with $\varepsilon \to 0$, $a_2 = a u_2$ and $a_3 = \Omega u_z$ (again $\Omega \to \infty$); $u_1$ y $u_2$ are two orthogonal unitary vectors possibly spinned with respect to $u_x$ (which is assumed to be taken in the direction of polarization) and $u_y$.

The reciprocal lattice is given by: $B_1 = \dfrac{u_2 \times u_z}{\varepsilon u_1 (u_2 \times u_z)} = u_1 / \varepsilon$, $\quad B_2 = \dfrac{u_z \times u_1}{a u_2 (u_z \times u_1)} = u_2 / a$,

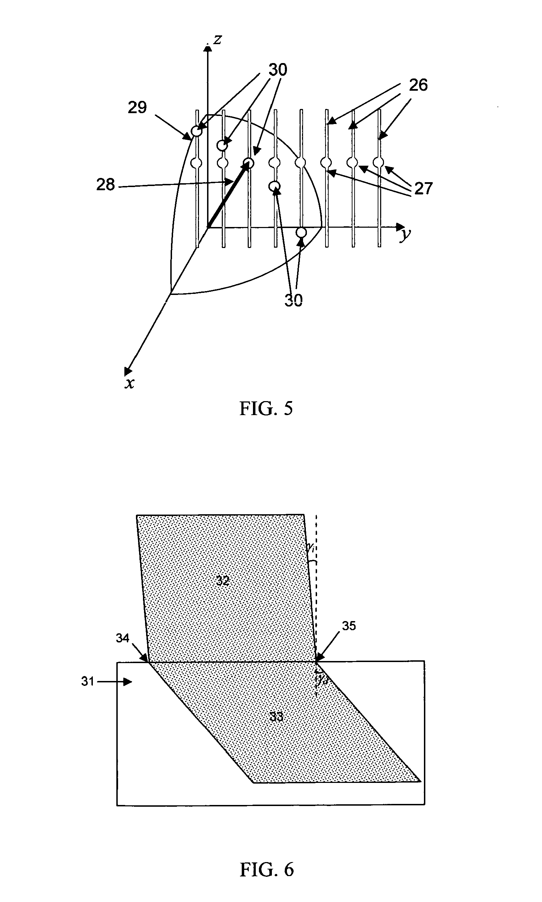

$B_3 = \dfrac{\varepsilon a u_1 \times u_2}{\Omega \varepsilon a u_z (u_1 \times u_2)} = u_z / \Omega$. Directions for onstructive diffraction (30) are now plotted in Figure 5. Notice that only one reciprocal vector line (multiplied by $\lambda_0$ and displaced by $u_0$) intersects the unit radius sphere. The dots in the resulting grid are separated by a distance $\lambda_0 / a$. The remaining lines are at a distance of at least $1/\varepsilon$, that is, in the infinite.

We are now ready to explain how to achieve the light confinement and how to optimize it. Refering to Figure 6, the area in which the light is to be confined is represented as a single block (31), and corresponds, for example, to the intermediate band region represented in Figure 1. Let us assume an illuminating plane wave (32) of wave vector $k_i$ ($u_i$ direction) forming a $\gamma_i$ angle with the vertical axis (normal to the diffractive surface) which is diffracted in a constructive interference direction (33) forming a plane wave of $k_d$ wave vector ($u_d$ direction) and forming a $\gamma_d$ angle with respect to the $z$ axis. Let us call $P_i$ ($P_i = u_i E_0^2 / \eta_i$ with $\eta_i$ the characteristic impedance of the medium) the Poynting vector representing the energy flux of the incident wave. The energy reaching the area between dots (34) and (35), separated by a distance $L$ between them will be $W = P_i L \cos \gamma_i$. Being this energy oriented towards the $u_d$ direction, the relation between this energy and the Poynting vector will be $W = P_d L \cos \gamma_d$. Therefore,

$$P_d = P_i \cos \gamma_i / \cos \gamma_d \qquad\qquad (6)$$

allowing the calculation of the electric field of the diffracted wave from this Poynting vector, as well as the photons flux. Obviously, the most inclined the diffracted plane wave, the higher its Poynting vector, reaching infinite for 90° inclinations.

The increase in power density achieved by diffraction can be doubled by means of total internal reflection on the layer (8) in Figure 1 as this layer reflects the plane waves by producing new plane waves with reflected wave vectors.

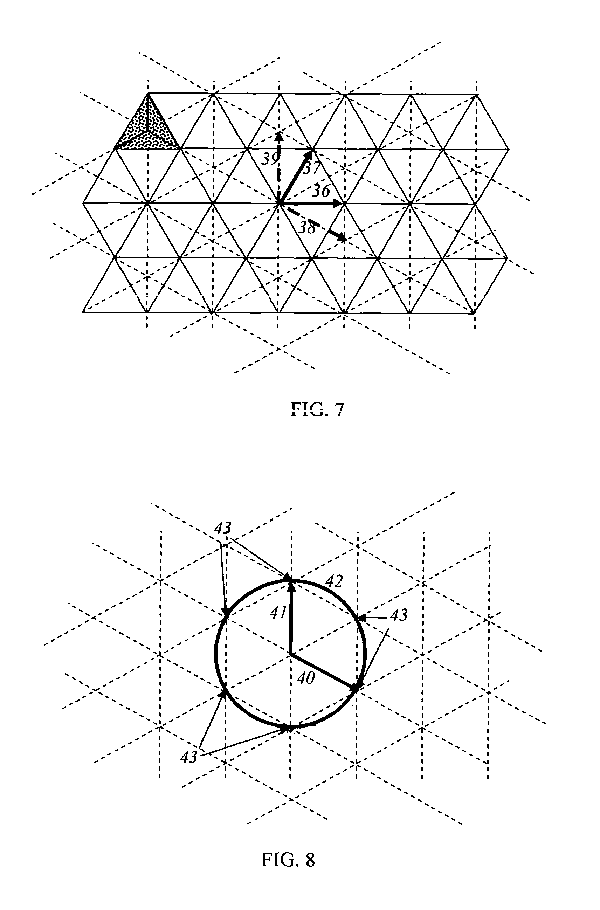

Let us now consider a series of inverted triangular pyramids. Each pyramid constitutes a diffraction centre as those studied above and their whole constitutes a bidimensional lattice with base vectors $a_1$ and $a_2$, both of a length, and respectively marked as (36) and (37) in Figure 7. Reciprocal base vectors $B_1$ and $B_2$ are marked as (38) and (39) and have all the same $2/a\sqrt{3}$ lenght. The grid of diffraction centres is marked with solid lines while the grid of reciprocal ones is marked using dashed lines. In Figure 8 the same reciprocal lattice is shown, although reduced by a $\lambda_0$ factor. Its base vectors (40) and (41) are now $\lambda_0 B_1$ and $\lambda_0 B_2$. The circle (42) on it, represents the projection of the unit radius sphere on the $x,y$ plane.

For illumination according to the $z$ axis, this is with $\gamma_i = 0$, the points in the reciprocal lattice are vertically displaced, although their projection on the $x,y$ plane does not change. Each node of the reciprocal lattice is the origin of a line parallel to the $z$ axis and, therefore, its intersection with the unit radius sphere represents a constructive direction for diffraction. Should it be adjusted in a way such that,

$$2\lambda_0 / a\sqrt{3} = 1 \qquad\qquad (7)$$

those lines will be tangent to the sphere at the points (43) what will determine the directions of constructive direction that are contained on the $x,y$ plane, that is with $\gamma_d = 90°$. Should equation (6) be applied, it can be observed that the power density of the diffracted wave is infinite (even assuming that only one finite fraction of the incident power is difftacted). Therefore, the power density is now optimized.

Nevertheless, a solar cell is not only illuminated by a plane wave coming from a single directon. In case of direct exposure to the sun, it will be illuminated by a light cone with a semiangle close to 0.26°. This cone is generally bigger (and maybe not axisymmetric) when coming from a concentrator.

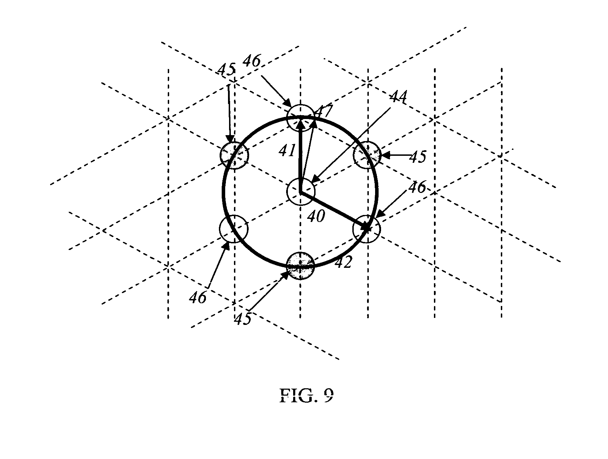

Assuming that the illumination cone is charactrised by a $\phi$ semiangle, wave vectors corresponding to the multiple plane waves proceeding from the illumination, configure a cone with equal semiangle. In Figure 9, the reciprocal lattice of Figure 8 is reproduced (that is, reduced by a $\lambda_0$ factor) and a circle (44) is included, centered in the origin of this reciprocal lattice, of radius $\delta = \sin\phi / n$ where $n$ is the refraction index of the medium including the quantum dots of the solar cell,and counts for the refraction of the illumination cone when reaching this medium. This circle contains the projection on the *xy* plane of all the wave vectors of the mentioned illumination cone. According to this explanation, the reciprocal lattice must shift in such a way that its origin lays on one of these projections. In this way, the remaining points of the reciprocal lattice describe a circle of the type (45) and (46), all of them with the same radius.

Obviously, in case of wide illumination, the above mentioned design is not possible. Now, directions of constructive diffraction must be ensured for each wave of the illumination cone. To this aim, the unit radius circle must go through the point (47) so the certain diameters of circles (45) and (46) are chords of the circle (12) of unit radious.

This condition imposses that the separation a between nodes of the direct grid must be such that

$$4\lambda_0^2/3a^2 + \delta^2 = 4\lambda_0^2/3a^2 + \sin^2\phi/n^2 = 1 \qquad (8)$$

By doing this, any illumination direction will have, at least, three directions of constructive interference, although the direction of vertical illumination and some others project on the *xy* plane, almost parallel to the directions of the diffraction grid centres, will have six.

The $\Lambda(\varphi,\theta)$ vector appearing in Equation (2) can be approximately calculated by optical geometry. Not considering its vectorial characteristic, the directions in which $\Lambda(\varphi,\theta)$ is large are those corresponding to the refraction of the illumination wave. Being $\psi$ the angle of the normal to the sides of the pyramid of triangular basis forming the diffraction centre, the inclination of the directions of diffraction for vertical illumination (according to *z* axis) is $\psi$-arcsen(sen $\psi/n$) according to optical geometry. This value will increase as $\psi$ and the refraction index become higher. Apart from the inclination, the refracted directions are on the vertical plane containing the normal to the sides of the pyramids, this is the $a_1$ vector. Other refracted directions can be found after two consecutive 120° rotations.

The solution based on optical geometry is specially aproximated for values of *a* much higher than the light wavelength. On the contrary, when they are much lower, the direction does not suffer refraction on the semiconductor when the illumination is along the *z* axis. In intermediate cases, lobes more or less marked can be produced on the aforementioned directions. On the other hand, for directions only close to *z*, refracted directions do not show considerable changes neither $\Lambda(\varphi,\theta)$.

As a consequence, after diffraction, constructive interference circles (45) carry more energy than the circles (46). On the other hand, the amount of energy carried by the circle without deflection (44) will depend on the size (higher energy with smaller size) and $\psi$ angle (less energy with higher angle). Carried energy is advisable to be low, so almost all of it is diffracted.

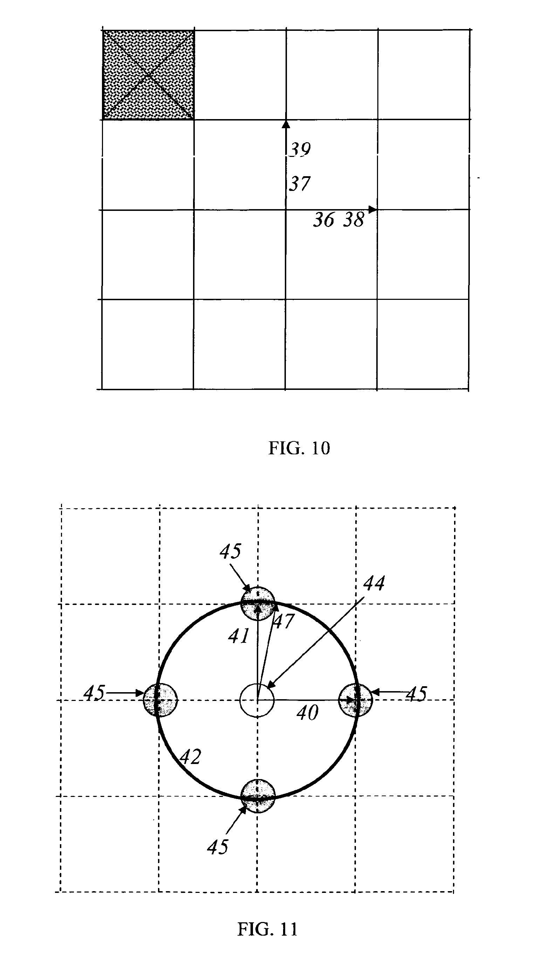

With a similar reasoning, a grid of pyramids of quadrangular base can be designed forming up a rectangular lattice as shown in Figure 10 reaching similar results. In this case, both the centre and the reciprocal lattice, being both of them quadrangular, are superimposed. Base vectors $a_1$ and $a_2$, both with *a* lenght are respectively marked as (36) and (37) in Figure 10. Reciprocal lattice base vectors $B_1$ and $B_2$ are those marked as (38) and (39); both with a length of 1/*a*. In this way, by chosing the proper scale, both nets become superimposed. In this case, as shown in Figure 11, with similar reasonings as those used when describing Figure 9, the optimum separation between diffraction centres is given by

$$\lambda_0^2/a^2 + \sin^2\phi/n^2 = 1 \qquad (9)$$

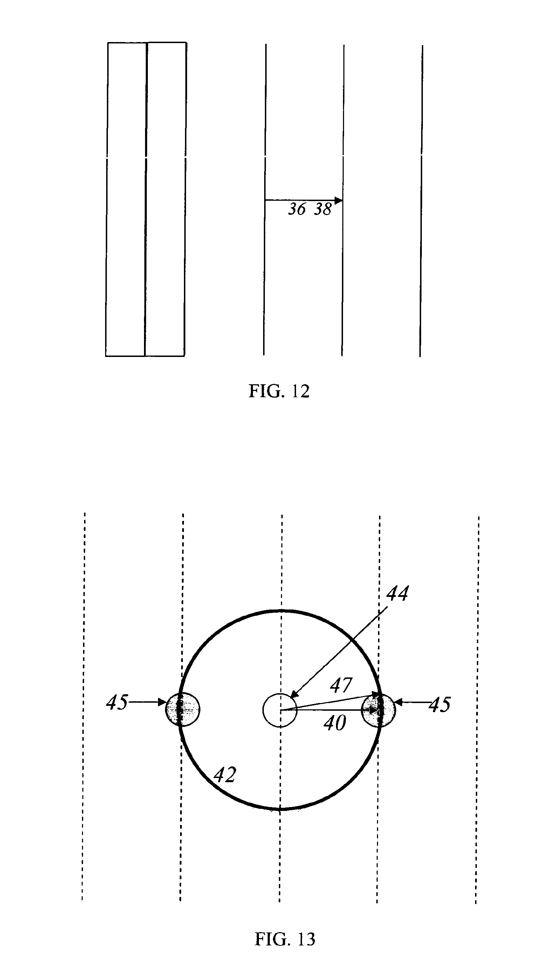

A diffraction grid as the one shown in Figure 12 can also be designed, in which the shadowed zone represents diedros like (9) in Figure 1. The optimum separation of the diffraction lines is given by equation (9) as it can be deducted from Figure 13.

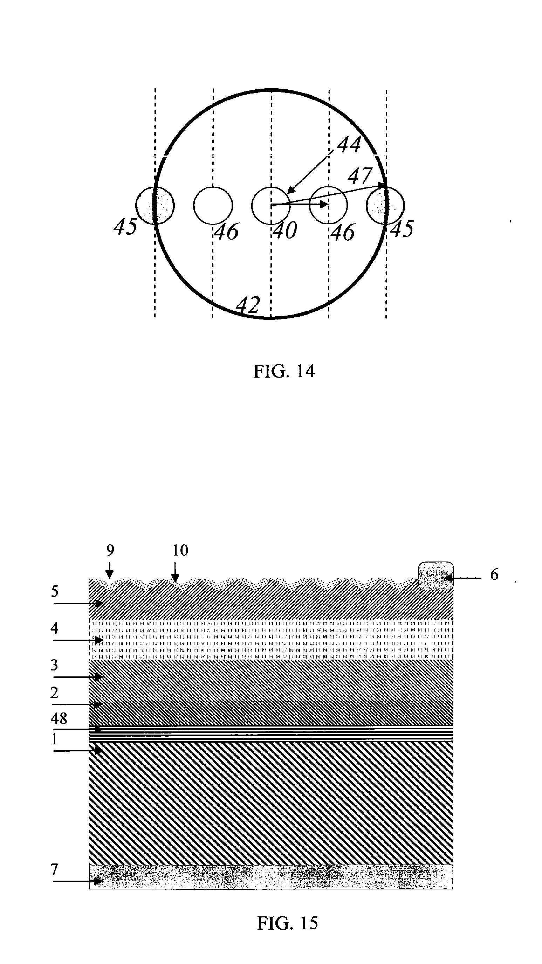

It can also be considered, depending on the wavelength of the light, the use of a second (or higher) diffraction order. This will allow increasing the size of the diffraction centres and, consequently, a better observation of the geometric optics and a more directive $\Lambda(\varphi,\theta)$ function. In this case, the separation between diffraction lines can be deducted from Figure 14.

$$4\lambda_0^2/a^2 + \sin^2\phi/n^2 = 1 \qquad (10)$$

A variant of the solar cell in Figure 1 is that described in Figure 15. A Bragg dielectric reflector (48) (formed by sucessively low and high refraction indexes semiconductor layers) is deposited either on, under, or in the middle of the buffer layer (2) to reflect upwards the almost horizontal driffacted plane waves. This layer substitutes layer (8) in Figure 1 and has the advantage of restricting the areas of high field to the active regions of the cell where less undesirable losses are produced by absorption by mechanisms different from those desired in an intermediate band cell.

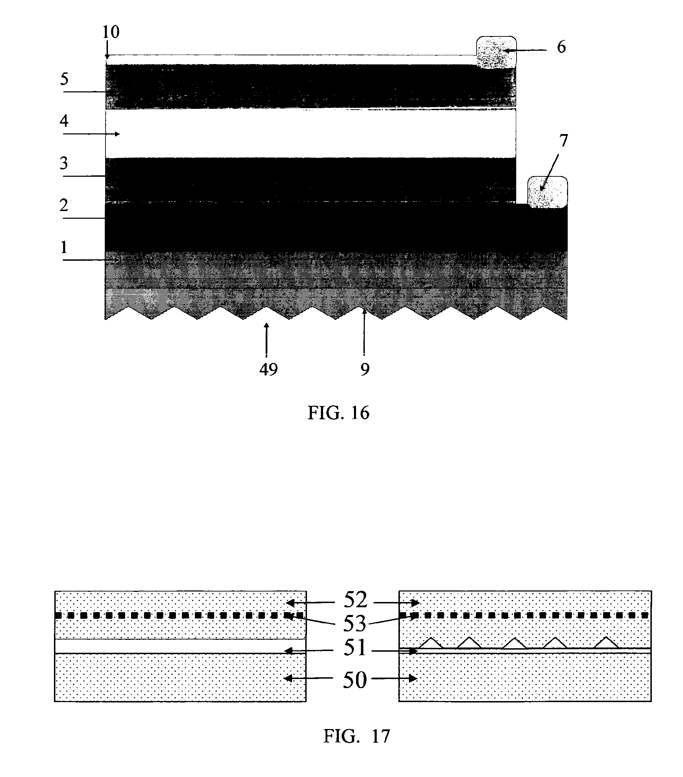

Another alternative to the structure of the intermediate band cell in Figure 1 is the one shown in Figure 16. The main difference is given by the substitution of the contact (7) at the rear side in Figure 1 by a side contact taken in the buffer layer (2). In this cell, the diffraction structure (9) is engraved on the lower face and operates by total internal reflection. Layer (49) is constituted by a medium of low refraction index which produces the total internal reflection of the light coming from the semiconductor and incident on the grid. It also contributes to the dissipation of the heat produced by the radiation inceeding on the cell. In this case, the antireflective layer (10) in Figure 16 is designed in the usual way for solar cells and can consist in fact of multilayer structure.

Up to now we have considered the the intermediate band material to be constituted by a quantum dots region. It is also possible to manufacture it by means of alloys. For example, according to our Patent WO2007068775A1, impurities able to produce deep centres (several transition metals) can produce intermediate bands, at the proper levels of concentration. Some isoelectronic impurities with rather different ionic radiuss can also do it, like in Patent WO2005055285A2.

## Description of Figures

**Figure 1:** Intermediate band solar cell layout, with optimum light coupling to the intermediate band material, consisting of a monocrystalline semiconductor substrate (1) onto which an epitaxial buffer layer is deposited (2) to separate and couple the substrate to the active regions of the cell, a n-type (or alternatively p-type) conductivity base epitaxial layer (3), an intermediate band material layer (4) and a p-type (or alternatively n-type) emitter layer (5). It also contains a metallic contact grid (6) on its upper face and another contact (7) on its rear side, which is partially separated from the semiconductor by a low refraction index layer (8). It also contains some grooves (9) on its frontal side covered with one or more antireflecting layers (10) also forming part of the difracting structure.

**Figure 2:** Band diagram of an intermediate band solar cell: intermediate band (11), semiconductor bandgap (12), intermediate band material (13), n-region to contact the conduction band (14), conduction band (15), p-region to contact the valence band (16), valence band (17), transition of an electron from the valence to the conduction band pumped by a photon (18), transition of an electron from the intermediate to the conduction band pumped by a photon (20), quasi-Fermi level of the electrons in the valence band (22), quasi-Fermi level of the electrons in the intermediate band (23).

**Figure 3:** Band diagram of a quantum dot intermediate band solar cell: intermediate band material (13), n-región to contact the conduction band (14), p-region to contact the valence band (16), potential energy of the quantum dots (24), energy levels of the electronic states confined into the quantum dots (25) which are those forming the intermediate band in this solar cell.

**Figure 4:** Tridimensional reciprocal lattice of a bidimensional grid of diffractive centres. It is formed by the lines (26) coming out from the elements (27) bidimensional reciprocal lattice with base determined by $B_1$ and $B_2$ and multiplied by $\lambda_0$ (that is, the base in Figure 4 is $B_1\lambda_0$ and $B_2\lambda_0$) displaced by the $u_0$ vector towards the illumination direction (28). Some of these lines are usually intersected with the unit radius sphere (29) as, for instante, the one numbered (30). Obviously the most external lines (26) do not have any intersection and therefore, do not produce constructive directions of diffraction.

**Figure 5:** Tridimensional reciprocal lattice of a diffraction grid formed by lines on a plane. The reciprocal lattice is formed by the lines (26) coming out from the elements (27) bidimensional reciprocal lattice with base $B_2$ multiplied by $\lambda_0$ (this is, the base in
Figure 4 is $B_2\lambda_0$) displaced by the $u_0$ vector towards the illumination direction (28). Some of these lines are usually intersected with the unit radius sphere (29) as, for instante, the one numbered (30). Obviously the most external lines (26) do not have any intersection and, therefore do not produce constructive directions of diffraction.

**Figure 6:** Zone where the light is to be confined (31), for example the intermediate band region represented in Figure 1 with its diffractive structure on the upper face.
Plane illumination wave (32) with $k_i$ wave vector ($u_i$ direction) forming a $\gamma_i$ angle with the vertical axis (normal to the difractive surface) which is difracted on a constructive interferente direction (33) creating a plane wave of $k_d$ wave vector ($u_d$ direction) with a $\gamma_d$ angle with respect to the $z$ axis.

**Figure 7:** Bidimensional diffraction grid constituted by a series of invertid triangular pyramids. Lattice base vectors $a_1$ and $a_2$, both of length $a$, are those respectively numbered (36) and (37). Reciprocal base vectors $B_1$ and $B_2$ are

those numbered (38) and (39); their length is $2/a\sqrt{3}$. The grid of diffraction centres is marked with solid lines, and the reciprocal, with dashed lines.

**Figure 8:** Reciprocal lattice of Figure 7 reduced by a $\lambda_0$ factor, with its base vectors (40) and (41), which now are $\lambda_0 B_1$ and $\lambda_0 B_2$. The circle (42) is the projection of the unit radius sphere on the *x,y* plane. The dots (43) are nodes of the reciprocal net, and the lines coming out from them, perpendicular to the drawing, are tangent to the unit radius sphere.

**Figure 9:** Reciprocal lattice multiplied by $\lambda_0$ as in Figure 8, in which the projected circle (44) on the *xy* plane corresponding to the illumination unitary vectors have been added. For each illumination vector into this circle, the nodes of the reciprocal lattice are displaced in parallel, so that the nodes close to the unit radius circumference (42) are displaced by dots in circles (45) and (46). Dot (47) marks the intersection of one of the circles (46) with the unit radius circle (42) and must take place in the intersection of the horizontal dimameter of the circle (46) with its circunference. In this way, the center of circles (45) and (46) is slightly moved into the unit radius circle (42). With the pyramids in Figure 7, circles (45) carry more energy than circles (46).

**Figure 10:** Grid of cuadrangular base pyramids forming a rectangular lattice. In this case, both the centre and the reciprocal lattice, both quadrangular shaped, are superimposed. Net base $a_1$ and $a_2$ vectors, with a lenght, are respectively numbered (36) and (37). Reciprocal base vectors $B_1$ and $B_2$ are those numbered (38) and (39); its length is $2/a\sqrt{3}$ (both lattices will be superimposed with the proper scale).

**Figure 11:** Reciprocal lattice as in Figure 10 multiplied by $\lambda_0$, in which the projected circle (44) on the *xy* plane corresponding to the unitary vectors of the illumination has been added. For each illumination vector inside this circle, the nodes of the reciprocal net are displaced in parallel in such a way that the nodes close to the unit radius circumference (42) are displaced by dots into the circles (45). Dot (47) points at the intersection of one of the circles (45) with the unit radius circle (42) and must be produced at the intersection of the horizontal diameter of the circle (45) with its circunference. In this way, the center of the circles (45) is slightly displaced into the unit radius circle (42).

**Figure 12:** Diffraction grid in which the shadowed zone represents diedros like (9) in Figure 1. (36) and (38) represent respectively the grid diffraction lattice vectors and their reciprocal.

**Figure 13:** Reciprocal lattice multiplied by $\lambda_0$ as in Figure 12, in which the projected circle (44) on the *xy* plane corresponding to the unitary vectors of the illumination has been added. For each illumination vector inside this circle, the nodes of the reciprocal lattice are displaced in parallel in such a way that the nodes close to the unit radius circumference (42) are displaced by dots into the circles, (45). Dot (47) points at the intersection of one of the circles (45) with the unit radius circle (42) and must be produced at the intersection of the vertical diameter of the circle (45) with its circunference. In this way, the center of the circles (45) is slightly displaced into the unit radius circle (42).

**Figure 14:** Reciprocal lattice multiplied by $\lambda_0$ as in Figure 12, in which the projected circle (44) on the *xy* plane corresponding to the unitary vectors of the illumination has been added. For each illumination vector inside this circle, the nodes of the reciprocal lattice are displaced in parallel in such a way that the nodes close to the unit radius circumference (42) are displaced by dots into the circles (45) and (46). In this case the separation among lines has been adjusted in order to allow the second diffraction order the closest to the circle (42). Due to the directivity of the $\Lambda$ function, circles (46) of the second order of diffraction, more inclined, carry more energy than those (45) of the first order. Dot (47) points at the intersection of one of the circles (45) with the unit radius circle (42) and must be produced at the intersection of the vertical diameter of the circle (45) with its circunference. In this way, the center of the circles (45) is slightly displaced into the unit radius circle (42).

**Figure 15:** Scheme of an intermediate band solar cell with optimum coupling of light into the intermediate band material, which consists of a monocrystalline semiconductor substrate (1) onto which an epitaxial buffer layer is deposited (2) to separate and couple the substrate of the active part of the cell, a n-type (or alternatively p-type) conductivity base epitaxial layer (3), an intermediate band material layer (4) and a p-type (or alternatively n-type) emitter (5). It also contains a metallic contact grid (6) on its upper face and another contact (7) on its lower face, which is partially separated from the semiconductor by a low refraction index layer (8). It also contains some grooves (9) on its front side covered with one or more antireflecting layers (10) also forming the difractive structure. Layer (48) is a Bragg reflector made up of several layers of alternative high and low reffraction index, designed to reflect the diffracted light, increasing its intensity in the active part of the solar cell.

**Figure 16:** Scheme of an intermediate band solar cell with optimum coupling of the light into the intermediate band material, which consists on a monocrystalline semiconductor substrate (1) onto which an epitaxial buffer layer is deposited (2) to separate and couple the substrate of the active part of the cell, a n-type (or alternatively p-type) conductivity base epitaxial layer (3), an intermediate band material layer (4) and an p-type (or alternatively n-type) emitter (5). It also contains a metallic contact grid (6) on its upper face and another contact (7) on the buffer layer (2). It also contains some grooves (9) on its rear side covered with a low reffraction index protective transparent layer (49) to produce total internal reflection in the frontier between this layer and the substrate (1). There is an antireflecting layer on the frontal face (10) which can also be a multilayer.

**Figure 17:** Fabrication of a quantum dot layer by the Stransky-Krastanov method. A layer (50) of the barrier material semiconductor is deposited, followed by a layer (51) of the dot material with a different lattice constant. Once some atomic monolayers of this last material are deposited, the layer collapses on a series of piramidal dots formed on a continuous wetting thin film. Then, a spacer layer (52) including a layer (53) of highly dopped material ($\delta$ dopping) is deposited.

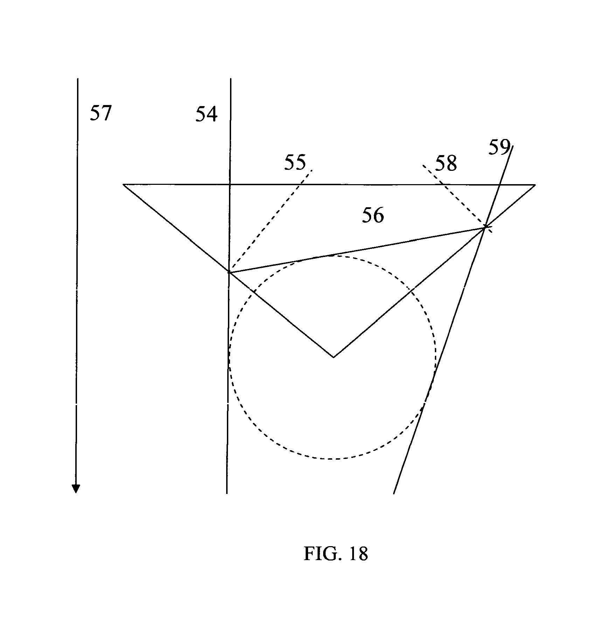

**Figure 18:** Detailed profile of one of the grooves (9) in Figure 16. The angles are calculated with respect to the axis (57). (55) and (58) are the normal lines to the facets.

A vertical ray (54) is reflected according to (56) and then again according to (59).

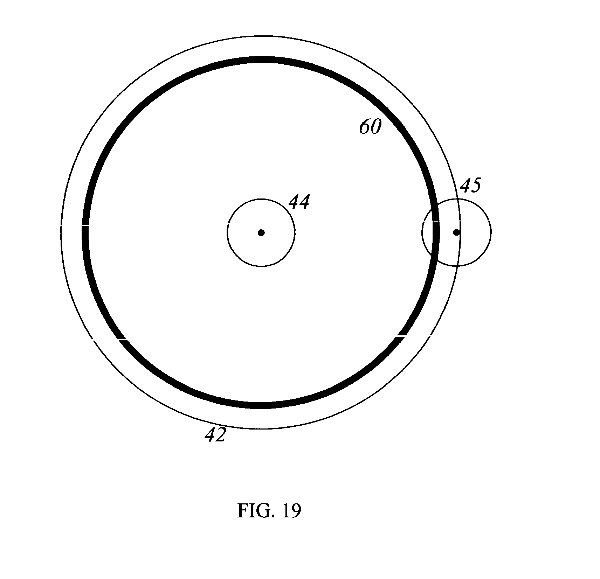

**Figure 19:** Calculation of the area that is common to the circles (42) and (45). To this aim, the elementary circular ring (60) is used.

## Description of a preferred embodiment

The specific implementaion we are now to consider is an example of one of those this invention can adopt. The basic structure is shown in Figure 16 consisting of a gallium arsenide (GaAs) substrate (1) of approximately 200 $\mu$m on which a 500 nm of $Al_{0.2}Ga_{0.8}As$ buffer layer (2) is deposited to act as a hole reflector, dopped with n-type silicon at a concentration of $1\times10^{18}$ cm$^{-3}$ to ease the current extraction, and a 3.2 $\mu$m of GaAs base layer (3) on its top, dropped with silicon at a concentration of $1\times10^{18}$ cm$^{-3}$. A region of quantum dots is then formed (4) and a 900 nm of GaAs emmiter layer, dopped with p-type berilium at a concentration $2\times10^{18}$ cm$^{-3}$ is deposited on it. In-between the antireflecting layer (10) made up of a double coat of ZnS y SiO$_2$ a window layer of 40 nm of $Al_{0.85}Ga_{0.15}As$ dopped with berilium at a concentration of $2\times10^{18}$ cm$^{-3}$ is placed in order to reduce surface recombination. Also, just below the metal there is a 300 nm of GaAs p dopped layer with berilium at a concentration of $5\times10^{19}$ cm$^{-3}$ to ease the ohmic contact.

Concerning the quantum dot region, as represented in Figure 17, each quantum dot layer is formed by a first layer (50) of 35 nm of GaAs onto which around 3 monolayers (51) of InAs atoms are deposited, followed by 50 nm of GaAs (52) containing in its certral part a silicon surface dopping (53) ($\delta$ dopping) with a dose of $4\times10^{10}$ atoms/cm$^2$. Due to the difference of latttice constants, the InAs monolayers contract into piramidal shaped drops, which are the desired quantum dots. Nevertheless, a wetting layer is produced at the same time, creating an effective reduction of the GaAs bandgap. The process is then repeated as many times as needed, in our case, 50 times. The size and number of the quantum dots will depend on the thickness of the InAs layers and on the deposition and post-deposition temperatures. The position of the energy levels is also related to the size of quantum dots. With this structure, the separation between the valence and conduction band is 1.3 eV including the reductions caused by the wetting layer and the valence band offset. The intermediate band is located around 0.4 eV below the modified conduction band. Absorption bands therefore appear above 0.4 eV, 0.9 eV and 1.3 eV corresponding to 3.01, 1.38 and 0.954 $\mu$m respectively. The solar cell is illuminated by wide band solar radiation. Photons with higher energy than the forbidden band are absorbed without any treatment. Our diffraction grid is intended to be designed to reach the optimum exploitation of 1 eV photons corresponding to a wavelength of 1.24 $\mu$m.

The mentioned deposits can be mady by molecular beam epitaxy, using the proper commertial equipment, although it is advisable to deposit the metal as well as the antireflecting layer using an *ad hoc* equipment, prefearably by electron gun.

Once all depositions are completed, the rear face of the cell must be engraved. To this aim, for instante when using InP substrate, its surface must point to the cristalographic direction (3,1,1) so that the compact planes (1,1,1) form an angle of 29.50° with it (see Kouichi Akahanea, Naoki Ohtania, Yoshitaka Okadab, Mitsuo Kawabeb, "Fabrication of ultra-high density InAs-stacked quantum dots by strain-controlledgrowth on InP(3 1 1)B substrate", Journal of Crystal Growth 245 (2002) 31-36), which we will prove to be the most convenient. If the rear side is covered with a photoresin and grooves are open towards the direction (0,-1,1) followed by a direccional atack, the asymmetric grooves shown in (9) in Figure 16 will appear, whose normal forms an angle with the vertical of $\gamma_F$=29.50°. These grooves will produce a quasi vertical plane opposite to the mentioned plane which, although it is not necessary, should be made to be symmetric by a plasm attack. Then the rear face of the the cell must be recovered with a transparent isolating layer with a reffraction index close 1.5 with the aim of protecting the surface against the grooves, as well as extracting the heat dissipated in the cell when it is exponed to high intensity illumination.

The deposition of the metallic grid contact is not explained here, as they are the ones commonly used for solar cell fabrication.

The limiting angle between the semiconductor, with a reffraction index close to $n=\sqrt{13}$ an the lower protective medium, of index 1.5 is $\arcsin\left(1.5/\sqrt{13}\right) = 24.58°$.

Concerning Figure 18, for normal incidence, ray (54) incides on the diffraction grid facet with an angle $\gamma_F$=29.50° being its normal (55) slightly not higher than the limiting angle, and therefore producing total internal reflection. This ray is reflected on the ray (56) forming the angle of 180°-2$\gamma_F$=121.0° shown in the Figure with the axis, this is, inclined upwards (more than 90°). This ray (56) forms with the normal (57) to the other facet an angle of 180°-3$\gamma_F$=91.5° which, being higher than 90°, implies that no second reflection will occur (should the reflected ray (59) have existed, it would have produced an angle of 4$\gamma_F$).

It is advisable to design the cell to operate at a high concentration to pay the cost of the solar cell, expensive by unit area, and also to decrease the voltage reduction associated to the intermediate band.

For ideal concentrators, it is verified that the concentration $C = n_{optica}^2 \sin^2 \phi_{salida} / \sin^2 \phi_{sol}$, being $n_{optica}$ the refraction index of the secondary optics, intimately related to the cell, and $\phi_{sol}$ and $\phi_{salida}$ the angles of the cone of rays coming from the sun and those illuminating the cell coming from the concentrator respectively. Assuming $1/\sin^2\phi_{sol}$ = 46050 , for an ideal concentrator without secondary optics and concentration $C$=500, the output angle would be $\phi_{salida}$=6.42°. Should an ideal concentrator being built with the same output angle and a secondary with $n_{optica}$=1.5, concentration would be $C$=1125. Obviating optical looses and assuming a good tracking, this concentrator could be operated at 1000 suns, which is a widely used concentration (see for example, C. Algora, E. Ortiz, et al. (2001). "A GaAs solar cell with an efficiency of 26.2% at 1000 suns and 25.0% at 2000 suns." IEEE Transactions on Electron Devices 48(5): 840-844).

This input cone is reduced due to the refraction in the semiconductor with an angle of $\phi_{refractado}$=arcsen(sin (6.42°)/√13=1.78°. For a ray inclined in an angle $\phi$ clockwise, the previously calculated angles will become: 180°-2$\gamma_F$ +$\phi_{refractado}$, 180°-3$\gamma_F$+$\phi_{refractado}$ and 4$\gamma_F$-$\phi_{refractado}$. In the most desfavourable case, the incident ray of this cone, forms an angle with the facet of 29.49°-1.78°= 27.71°, this is, still higher than the limiting angle of 24.58°, so the total internal reflection is ensured. Some reflected rays could suffer a very tilted reflection on the second facet, which almost does not affect their direction.

Obviously, previous results are only valid in the field of geometric optics and not necessarily on the field of diffraction. Nevertheless, they give a first approximation that establishes that the function $\Lambda(\varphi,\theta)$ is provided with a lobe of a great importance for the angle $\varphi$=121.0° (from the vertical downwards, that is pointing upwards) and negligible in the direction of the incoming light.

The separation between lines of diffraction must satisfy Equation (9). Given that the wavelength of interest corresponds to photons of 1.24 μm in vacuum or 1.24/√13=0.344 in the semiconductor, we will obtain $a$=0.344 μm for $\phi$=6.42°.

The concentration for illumination with a single plane wave is given by Equation (6). Constructive diffraction directions are located in the common area to the circles (42) and (45) in Figure 19 (another symmetric circle (45) on the left side of the figure is not considered now). This area can be calculated by using an elementar circular ring (60) with a $d\rho$ thickess. In this graphic, $\cos\gamma_d = \sqrt{1-\rho^2}$. On the other hand, let us consider cos $\gamma_i$=1 for all the illumination plane waves. Consequently,

$$P_d / P_i = \int_{\sqrt{1-\delta^2}-\delta}^{1} \frac{2\theta(\rho,\phi)}{\sqrt{1-\rho^2}} d\rho \Bigg/ \int_{\sqrt{1-\delta^2}-\delta}^{1} 2\theta(\rho,\phi)d\rho \qquad (11)$$

where δ=sin$\phi$/$n$ y θ is the intersection of the circle semiangle (45) and the elementary ring (60) given by

$$\theta(\rho,\delta) = \arctan\left[\frac{\sqrt{1-\delta^2}}{1-2\delta^2+\rho^2}\sqrt{\frac{4\delta^2-4\delta^4-(1-\rho^2)^2}{1-\delta^2}}\right] \qquad (12)$$

The calculation of Equation (11) for the previously used value of $\phi$ is $P_d/P_i$=8.858.

This result must be interpreted as follows: most of the plane waves of the illumination cones are diffracted either to the left or the right side after passing through the cell (output diffraction is despictable) with the proper angles to produce the above mentioned concentration. These diffracted waves suffer an internal total reflection on their upper face and illuminate the quantum dots with plane symmetric waves able to duplicate the reached concentration. With respect to this new illumination, the diffraction grid (by time micro-reversibility) diffacts back the light upwards, producing the loss of the not absorbed scaping light. In summary, the concentration of the illumination of quantum dots is 8.858+8.858+1+1=19.716 (being "1" the quasi vertical transits of incoming and outcoming waves). A few illumination directions suffer from an inicial diffraction of quasi-equal value in both left and right direction. In this case reflection of the upper face derives in a global situation, equal to the one already describe.

Previous statements are valid for light of 1.24 $\mu$m (in vacuum). For lower wavelengths concentration progressively decreases.

In summary, with this diffraction grid, absorption in the quantum dots layer can be increased up to 20 times its thickness.

The most direct industrial application of the object of this invention is the increase of light absorption by the intermediate band of the intermediate band solar cells. These cells have been manufactured with quantum dots, which; due to their inherent low density, absorb little light. It must also be added the fact that quantum dots do not allow the manufacturing of thick layers, as their formation could spoil the semiconductor material due to the imbalance between cumulated strains. On the other hand, manufacturing prices are also high.

This invent would highly increase the intensity of the light of the appropriate photons in the quantum dots area. In this way, the quantum dot intermediate band cell can present a high absorption of light below the forbidden band and, therefore, develope the performance potencial promised by this kind of cells, but not yet reached.

The presented way of realization of our invention, shows an optimized design for a cell operating at high concentration. Its interest relies on the demosntration of its viability in these cases, even at very high concentration. The use of such high concentration is interesting not only for the significant price reduction of these inherently expensive cells by area unit (although cheap by produced kWh in concentrators) but also for the elimination of undesirable effects that reduce the reachable voltage.

On the other hand, this patent describes an unprecedent optimized method for designing diffraction nets and structures also interesting for other solar cells reaching low absorption levels and, particularly, in many thin film cells.

**Claims**

1. Intermediate band solar cell **characterized** for the inclussion of a grid of centres or diffraction lines either on the front or the rear face or even on an internal layer of the cell between two different reffraction index materials, deviating sunlight laterally into the cell, and increasing the light' absorption as the number of transitions also increase (in these kind of cells, transitions occur either between the valence and the intermediate band, between the intermediate and the conduction band, or even simultaneously.

2. Intermediate band solar cell, according to Claim 1, **characterised** for the centres or difraction lines separating to media of different difraction index are made of:

    - pyramids of polygonal base.
    - planes forming a diedro
    - any of the above repeated according to a periodical pattern.

3. Intermediate band solar cells, according to claims 1 to 2, in which the centres or difraction lines are spaced in a way that for at least one of the directions of illumination and for photons of a given wavelenfth in vacuum, the directions of constructive interference are parallel to the plane in which the solar cell is fabricated.

4. Intermediate band solar cell, according to claims 1 to 3, **characterised by** including a dielectric Bragg reflector (48) (made up by sucessive layers of low and high reffraction indexes semiconductor) placed, on, under or in the middle of the buffer layer (2) with the aim of refflecting diffracted quasi-horizontal plane waves.

5. Intermediate band solar cell, according to Claim 1 to 3 or 4 **characterized by** the lower metallic contact (7) is substituted by a side metallic contact taken from the buffer layer (2) in order to easy the acces to the rear face of the cell, so the diffraction structure (9) can be engraved on it and operates at total internal reflection.

6. Intermediate band solar cell according to Claims 1 to 3 or 4 or 5 **characterised by** the intermediate band materias is formed by a quantum dot matrix or by alloys that incorporate deep centres into the semiconductor.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

## INTERNATIONAL SEARCH REPORT

| | |
|---|---|
| International application No. | |
| PCT/ ES 2008/000631 | |

**A. CLASSIFICATION OF SUBJECT MATTER**

see extra sheet

According to International Patent Classification (IPC) or to both national classification and IPC

**B. FIELDS SEARCHED**

Minimum documentation searched (classification system followed by classification symbols)

H01L, G02F

Documentation searched other than minimum documentation to the extent that such documents are included in the fields searched

Electronic data base consulted during the international search (name of data base and, where practicable, search terms used)

INVENES,EPODOC, WPI, IEEE

**C. DOCUMENTS CONSIDERED TO BE RELEVANT**

| Category* | Citation of document, with indication, where appropriate, of the relevant passages | Relevant to claim No. |
|---|---|---|
| A | LUQUE,A. Fraunhofer ISI. Projects of the Department Energy Policy and Energy Systems. Basic Research and Innovative Science for Energy (BRISE). Nuevos conceptos para the conversión fotovoltaica of leaenergía solar con muy alta eficiencia. [Disponible in Internet 09/Jun/2007]. [Recuperado 19/Feb/2008]. <URL: http://www.isi. fraunhofer.de/e/eng/projekte/BRISE/ LUQUE_BRISE_2405.pdf> | 1-6 |
| A | EP 1130657 A2 (UNIV MADRID POLITECNICA ; UNIV MADRID AUTONOMA ; CONSEJO) 05.09.2001, paragraphs [0019-0022]. | 1-6 |
| A | LUQUE, A. The confinement of light in solar cells. Solar Energy Materials, Vol.23 (1991), pages 152-163. ISSN 0165-1633. | 1-6 |

☐ Further documents are listed in the continuation of Box C.   ☒ See patent family annex.

| | | |
|---|---|---|
| * | Special categories of cited documents: | |
| "A" | document defining the general state of the art which is not considered to be of particular relevance. | |
| "E" | earlier document but published on or after the international filing date | |
| "L" | document which may throw doubts on priority claim(s) or which is cited to establish the publication date of another citation or other special reason (as specified) | |
| "O" | document referring to an oral disclosure use, exhibition, or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other documents , such combination being obvious to a person skilled in the art

"&" document member of the same patent family

| Date of the actual completion of the international search | Date of mailing of the international search report |
|---|---|
| 10.January.2009        (10.01.2009) | **(11/02/2009)** |
| Name and mailing address of the ISA/ O.E.P.M. Paseo de la Castellana, 75 28071 Madrid, España. Facsimile No.  34 91 3495304 | Authorized officer J. A. Peces Aguado Telephone No. +34 91349 68 70 |

Form PCT/ISA/210 (second sheet) (July 2008)

## INTERNATIONAL SEARCH REPORT

Information on patent family members

| International application No. |
|---|
| PCT/ ES 2008/000631 |

| Patent document cited in the search report | Publication date | Patent family member(s) | Publication date |
|---|---|---|---|
| EP 1130657 A | 05.09.2001 | ES 2149137 AB<br>WO 0077829 A<br>US 6444897 B | 16.10.2000<br>21.12.2000<br>03.09.2002 |

Form PCT/ISA/210 (patent family annex) (July 2008)

**INTERNATIONAL SEARCH REPORT**

| International application No. |
| --- |
| PCT/ ES 2008/000631 |

CLASSIFICATION OF SUBJECT MATTER

*H01L 31/052* (2006.01)
*G02F 1/29* (2006.01)

Form PCT/ISA/210 (extra sheeet) (July 2008)

## REFERENCES CITED IN THE DESCRIPTION

### Patent documents cited in the description

- EP 1130657 A2
- EP P9901278 A2
- US 6444897 B
- US 4398056 A
- US 4536608 A
- WO 9214270 A
- JP 8046227 B
- JP 2001127313 B
- WO 2007068775 A1
- WO 2005055285 A2

### Non-patent literature cited in the description

- **A. Luque ; A. Martí ; C. Stanley ; N. López ; L. Cuadra ; D. Zhou ; A. Mc- Kee.** *Journal of Applied Physics,* 2004, vol. 96, 903
- **RH Morf ; H Kiess.** Submicron gratings for light trapping in silicon solar cells: a theoretical study. *Proc. 9th Photovoltaic Solar Energy Conf.,* 1989, 313-315
- **A. Luque.** The Confinement of Light in Solar-Cells. *Solar Energy Materials,* December 1991, vol. 23, 152-163
- **A. Martí ; E. Antolin ; E. Cánovas ; N. López ; A. Luque ; C. Stanley ; C. Farmer ; P. Diaz ; C. Christofides ; M. Burhan.** Progress in quantum-dot intermediate band solar cell research. *Proc. of the 21st European Photovoltaic Solar Energy Conference, Munich: WIP-Renewable Energies,* 2006, 99-102
- **Kouichi Akahanea ; Naoki Ohtania ; Yoshitaka Okadab ; Mitsuo Kawabeb.** Fabrication of ultra-high density InAs-stacked quantum dots by strain-controlledgrowth on InP(3 1 1)B substrate. *Journal of Crystal Growth,* 2002, vol. 245, 31-36
- **C. Algora ; E. Ortiz et al.** A GaAs solar cell with an efficiency of 26.2% at 1000 suns and 25.0% at 2000 suns. *IEEE Transactions on Electron Devices,* 2001, vol. 48 (5), 840-844